# EUROPEAN PATENT APPLICATION

(11) **EP 3 808 870 A1**
(43) Date of publication of application: **21.04.2021**
(21) Application number: 19214924.3
(22) Date of filing: 10.12.2019
(51) Int. Cl.: C23C 16/08, C23C 16/40, C23C 16/455, C23C 28/04, C23C 22/04, C23C 22/56

(54) **LOW TEMPERATURE ATOMIC LAYER DEPOSITED TOPCOATS FOR PRETREATED ALUMINUM**

(30) Priority: 17.10.2019 US 201916655959
(71) Applicant: Hamilton Sundstrand Corporation, Charlotte, NC 28217-4578 (US)
(72) Inventor: POTEET, Steven, Ashland, MA 01721 (US); SMITH, Blair A., South Windsor, CT 06074 (US); PIMENTEL, Katherine Urena, Manchester, CT 06042 (US)
(74) Representative: Dehns

(57) **Abstract**

A method for coating a substrate includes forming a conversion coat layer, depositing a protective coat onto the protective coat onto the conversion coat, and depositing a corrosion resistant top coat onto the protective coat. The conversion coat layer is formed by subjecting the substrate to a chemical or electro-chemical process. The protective coat is deposited using a first atomic layer deposition. The corrosion resistant top coat is deposited using a second atomic layer deposition. The conversion coat layer has a volatizing temperature, and the first atomic layer deposition is performed at a deposition temperature that is no greater than 1.3 times the volatizing temperature of the conversation coat layer, calculated in Kelvin.

## Description

### BACKGROUND

The present disclosure relates generally to corrosion barrier coatings. More specifically, this disclosure relates to corrosion barrier coatings of heat exchangers.

Many components within an aircraft are coated with corrosion barriers to increase the useful life of the components by increasing the corrosion resistance of the components. There are various environmental insults that may be present in, for example, a gas turbine engine under load such as cyclic high temperatures. Some conventional corrosion barriers are able to partially mitigate the impact of corrosive environments within the aircraft. However, internal surfaces of some of these components may be non-line of sight and many conventional corrosion barrier systems are unable to coat the internal surfaces of components with complex internal geometries. Additionally, it is difficult to uniformly apply conventional corrosion barriers, leaving some areas inadequately covered and other areas thickened to the point of chipping off. These uncovered, inadequately covered, or chipped off areas are more prone to corrosion and degradation of the component at these sites, reducing the component's useful life.

### SUMMARY

A method for coating a substrate includes forming a conversion coat layer, depositing a protective coat onto the protective coat onto the conversion coat, and depositing a corrosion resistant top coat onto the protective coat. The conversion coat layer is formed by subjecting the substrate to a chemical or electro-chemical process. The protective coat is deposited using a first atomic layer deposition. The corrosion resistant top coat is deposited using a second atomic layer deposition. The conversion coat layer has a volatizing temperature, and the first atomic layer deposition is performed at a deposition temperature that is no greater than 1.3 times the volatizing temperature of the conversation coat layer, calculated in Kelvin.

A coated metal article including a substrate with a conversion coat layer, an atomic layer deposited protective coat deposited onto the conversion coat layer, and an atomic layer deposited corrosion resistant top coat deposited onto the protective coat. The conversion coat layer has a volatizing temperature and the protective coat has an atomic layer deposition temperature window. The atomic layer deposition temperature window has an upper and lower limit. The lower limit is no greater than 1.3 times the volatizing temperature, calculated in Kelvin.

A coated heat exchanger including a substrate with a conversion coat layer, an atomic layer deposited protective coat deposited onto the conversion coat layer, and an atomic layer deposited corrosion resistant top coat deposited onto the protective coat. The conversion coat layer has a volatizing temperature and the protective coat has an atomic layer deposition temperature. The atomic layer deposition temperature is no greater than 1.3 times the volatizing temperature, calculated in Kelvin.

### BRIEF DESCRIPTION OF THE DRAWINGS

FIG. 1 is a cross-sectional view of a coated substrate.
FIG. 2 is a cross-sectional view of a substrate coated with a nano-laminate.
FIG. 3 is a flow chart showing the process for forming a non-line-of-site topcoat for pretreated aluminum.
FIG. 4 is a cross-sectional view of a heat exchanger coated with a non-line-of-site topcoat for pretreated aluminum.
FIG 5A-5C are a series of photographs showing the before and after results of salt spray testing on coated aluminum alloy substrates.
FIG 6A-6D are a series of photographs showing the before and after results of acid submersion testing on coated aluminum alloy substrate sample.

### DETAILED DESCRIPTION

Gas turbine engine corrosion is a common problem and can be linked to contaminants present in air inlet systems, water systems, and fuel systems. For example, trace amounts of sulfur oxides and nitrogen oxides present in these systems can react with moisture in the air to create acidic environments within the gas turbine engine, including heat exchanger units. These acidic environments greatly increase the oxidation rate of metallic components within the engine if not properly protected.

Heat exchangers, in particular, are typically designed with complex internal geometries in order to maximize the transfer of heat between two mediums. As such, many heat exchangers include a torturous flow path, which makes it very difficult to apply a corrosion barrier system deep within the core of the heat exchanger using conventional coating techniques, such as dipping, immersion baths, and spray coating. This leaves the uncoated or inadequately coated internal metallic surfaces within the heat exchanger prone to corrosive damage.

Atomic layer deposition (ALD) can be used as a method of applying corrosion resistant top coats to metal substrates. Corrosion resistant top coats applied by ALD, however, do not adhere well to metal substrates such as, for example, aluminum and aluminum alloys. Conversion coats that could act as a bonding layer for corrosion resistant top coats applied by ALD have volatizing temperatures far below the temperatures required to perform ALD for the corrosion resistant top coats, thereby limiting the conversion coat's effectiveness as a bonding layer for ALD.

As described herein, certain protective coats such as, for example, titanium dioxide, can be applied using a low temperature ALD. These protective coats adhere well to the conversation coat, without significantly volatizing the conversion coat during the ALD process. Once the protective coat has been deposited, additional corrosion resistant top coats can be applied using ALD at the required higher temperatures without volatizing the conversion coat underneath. The resulting coating has the anti-corrosion benefits of the corrosion resistant top coat, the adhesion benefits of the conversion coat, and the even, uniform non-line-of-site coating provided by ALD.

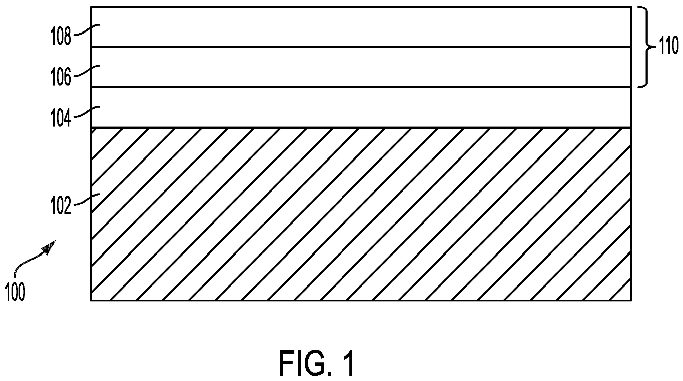

FIG. 1 is a cross-sectional view of a coated substrate. FIG. 1 shows component 100, metal substrate 102, conversion coat layer 104, protective coat 106, corrosion resistant top coat 108, and total ALD deposited coating thickness 110.

Component 100 can be any suitable article that requires protection from corrosive environments. Examples include, heat exchangers, air cycle machines, ductwork, air conditioning systems, electronic boxes, heat sinks, and automobile parts. Metal substrate 102 is a substrate that is susceptible to corrosion. The substrate can be made of a metal or metal alloy, for example aluminum, aluminum alloy, copper, copper alloy, tin, tin alloy, bismuth, bismuth alloy, indium, indium alloy, magnesium, magnesium alloy, nickel, or steel. In further embodiments, metal substrate 102 can be aluminum or aluminum alloy.

Conversion coat layer 104 is a layer on metal substrate 102 that is created by subjecting the surface of metal substrate 102 to a chemical or electro-chemical process to create a protective substance. The protective substance is conversion coat layer 104. In some embodiments, conversion coat layer 104 can comprise hexavalent chromium, trivalent chromium, Mo, Mn, Zr, Ti, Ni, Zn, V, P, Co, La, Ce, or rare earth metals, or combinations thereof, for example. In additional embodiments, conversion coat layer 104 can be an oxidation layer. Conversion coat layer 104 can have a thickness of at least 1 nm to no more than 500 nm, at least 5 nm to no more than 250 nm, or at least 10 nm to no more than 100 nm, for example. Conversion coat layer 104 has a volatizing temperature at which conversion coat layer 104 is vaporized. In some embodiments, the volatizing temperature is no less than 75°C, no less than 80°C, or no less than 90°C, for example. Conversion coat layer 104 provides some corrosion protection on its own, should corrosion resistant top coat 108 be compromised, but it may not perform well in long term acidic or saline environments, for example.

Protective coat 106 is a layer which can be deposited using ALD at a temperature that will not volatize a significant portion of conversion coat layer 104. Significant can be, for example no more than 10% of conversion coat layer 104, no more than 5% of conversion coat layer 104, or no more than 1% conversion coat layer 104 by weight, for example. Protective coat 106 has an ALD temperature window in which ALD can be performed. In some embodiments, the lower limit of the temperature window is no greater than 1.3 times, 1.2 times, or 1.1 times the volatizing temperature, calculated in Kelvin. In some embodiments, protective coat can be deposited using ALD at no greater than 150°C, no greater than 130°C, or no greater than 120°C, for example. In some embodiments, the protective coat comprises titanium dioxide. In some embodiments, protective coat 106 can have a thickness of at least 1 nm to no more than 500 nm, at least 5 nm to no more than 250 nm, or at least 10 nm to no more than 100 nm, for example. Multiple layers of protective coat 106 can be applied. In further embodiments, the protective coat can be part of a nano-laminate described further below. Protective coat 106, prevents conversion coat layer 104 from being further volatized during subsequent ALD processes.

Corrosion resistant top coat 108 is a uniform layer covering protective coat 106, including visible and non-line of sight surfaces of component 100. For example, a heat exchanger with complex internal geometries will be uniformly coated with a layer deep within the core of the heat exchanger.

Corrosion resistant top coat 108 is applied using atomic layer deposition (ALD) and can be formed of any elements or compounds compatible with ALD. For example, corrosion resistant top coat 108 can be selected from the group consisting of a metal oxide, metal nitride, semiconductor, phosphor, fluoride, or combinations thereof. In some embodiments, corrosion resistant top coat 108 can be Nb₂O₅.

Metal oxides, for example, can be selected from the group consisting of Al₂O₃, TiO₂, ZrO₂, HfO₂, Ta₂O₅, Nb₂O₅, Sc₂O₃, Y₂O₃, MgO, B₂O₃, SiO₂, GeO₂, La₂O₃, CeO₂, PrOx, Nd₂O₃, Sm₂O₃, EuOₓ, Gd₂O₃, Dy₂O₃, Ho₂O₃, Er₂O₃, Tm₂O₃, Yb₂O₃, Lu₂O₃, SrTiO₃, BaTiO₃, PbTiO₃, PbZrO₃, BiₓTi_{y}O, BiₓSi_{y}O, SrTa₂O₆, SrBi₂Ta₂O₉, YScO₃, LaAlO₃, NdAlO₃, GdScO₃, LaScO₃, LaLuO₃, LaYbO₃, Er₃Ga₅O₁₃, In₂O₃, In₂O₃:Sn, In₂O₃:F, In₂O₃:Zr, SnO₂, SnO₂:Sb, Sb₂O₃, ZnO, ZnO:Al, ZnO:B, ZnO:Ga, RuO₂, RhO₂, IrO₂, Ga₂O₃, VO₂, V₂O₅, WO₃, W₂O₃, NiO, CuOₓ, FeOₓ, CrOₓ, CoOₓ, MnOₓ, LaCoO₃, LaNiO₃, LaMnO₃, La₁-xCaₓMnO₃, and combinations thereof.

Metal nitrides, for example, can be selected from the group consisting of BN, AlN, GaN, InN, Si₃N₄, Ta₃N₅, Cu₃N, Zr₃N₄, Hf₃N₄, LaN, LuN, TiN, Ti-Si-N, Ti-Al-N, TaN, NbN, MoN, WNₓ, WNₓC_{y}, CoₓN, SnₓN, and combinations thereof.

Semiconductors, for example, can be selected from the group consisting of ZnS, ZnSe, ZnTe, CaS, SrS, BaS, CdS, CdTe, MnTe, GaAs, AlAs, AlP, InP, GaP, InAs, PbS, SnS, In₂S₃, Sb₂S₃, CuₓS, CuGaS₂, WS₂, SiC, Ge₂Sb₂Te₅, and combinations thereof.

Phosphors, for example, can be selected from the group consisting of ZnS:M (M=Mn,Tb,Tm); CaS:M (M=Eu, Ce, Tb, Pb); SrS:M(M=Ce, Tb, Pb), and combinations thereof.

Fluorides, for example, can be selected from the group consisting of CaF₂, SrF₂, MgF₂, LaF₃, ZnF₂, and combinations thereof.

Corrosion resistant top coat 108 can also be formed of elements or compounds, for example, selected from the group consisting of Ru, Pt, Ir, Pd, Rh, Ag, Cu, Ni, Co, Fe, Mn, Ta, W, Mo, Ti, Al, Si, Ge, La₂S₃, Y₂O₂S, TiCₓ, TiS₂, TaCₓ, WCₓ, Ca₃(PO₄)₂, CaCO₃, and combinations thereof.

Corrosion resistant top coat 108 can be made up of a mono layer deposited by ALD. In some embodiments, corrosion resistant top coat 108 can have a thickness of at least 1 nm to no more than 500 nm, at least 5 nm to no more than 250 nm, or at least 10 nm to no more than 100 nm, for example. Multiple layers of corrosion resistant top coat 108 can be applied. In some embodiments layers of corrosion resistant top coat 108 can be alternated with layers of protective coat 106 and/or other materials. In further embodiments, the corrosion resistant top coat can be part of a nano-laminate described further below. Corrosion resistant top coat 108 provides long term corrosion resistance in long term acidic or saline environments.

Total ALD deposited coating thickness 110 is the total thickness of the coating on the substrate of all layers that have been deposited by ALD. Total ALD deposited coating thickness 110 can be, for example, at least 1 nm to no greater than 500 nm, at least 5 nm to no greater than 490 nm, or at least 10 nm to no greater than 475 nm, for example.

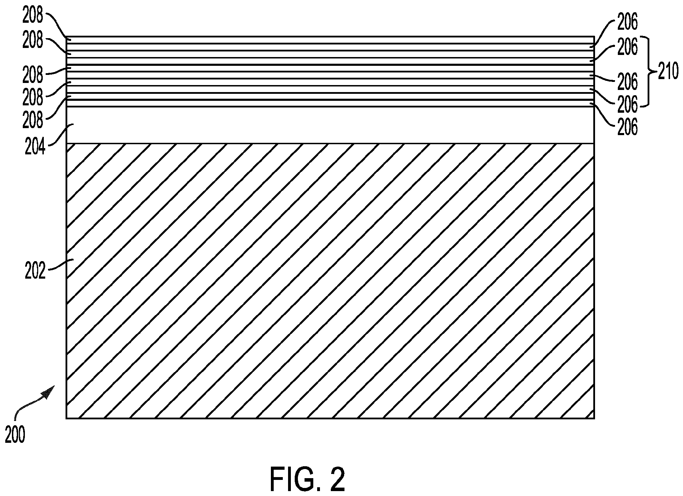

FIG. 2 is a cross-sectional view of a substrate coated with a nano-laminate. FIG 2 shows component 200, conversion coat layer 204, protective coat 206, corrosion resistant top coat 208, and total ALD deposited coating thickness 210 as described above.

Substrate 202 of component 200 is covered in conversion coat layer 204. Protective coat 206 is then layered with corrosion resistant top coat 208 in an alternating fashion, with a layer of corrosion resistant top coat 208 being the outer most layer. Protective coat 206 can have a thickness of at least 1 nm and no greater than 30 nm, at least 5 nm and no greater than 25 nm, or at least 10 nm and no greater than 20 nm, for example. Individual layers of protective coat 206 can be the same thickness or a different thickness from each other. Corrosion resistant top coat 208 can have a thickness of at least 1 nm and no greater than 30 nm, at least 5 nm and no greater than 25 nm, or at least 10 nm and no greater than 20 nm, for example. Individual layers of corrosion resistant top coat 208 can be the same thickness or a different thickness from each other. Layers of protective coat 206 and layers of corrosion resistant top coat 208 can be the same thickness or a different thickness from each other. Layers of additional material can be interspersed between the layers of protective coat 206 and corrosion resistant top coat 208. Nano-laminates allow for fine tailoring of the features of the overall coating, as well as increased protection against cracking and thermal expansion and contraction.

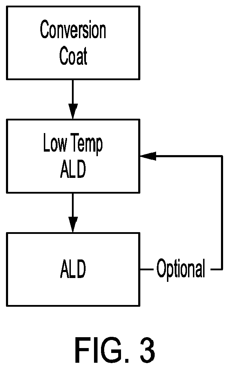

FIG. 3 is a flow chart showing the process for forming a non-line-of-site topcoat for pretreated aluminum. FIG. 3 shows that a conversion coat is applied, then a protective coat is deposited using low temperature ALD, then a corrosion resistant top coat is deposited using ALD. Optionally, the process is repeated to create a laminate or nano-laminate as described above.

Conversion coat layer can be created by applying a non-rinse conversion coat containing hexavalent chromium such as, for example, Permatreat® 686A (Chemetall, Auckland, New Zealand) or BONDERITE® M-CR 600 AERO or BONDERITE® M-CR 1200 AERO (Henkel Corp., Dusseldorf, Germany). However, hexavalent chromium is a hazardous compound to work with and poses a significant environmental threat if not handled and disposed of properly. As such, conversion coat can be applied using a non-hexavalent chromium containing conversion coat, having ions selected from the group consisting of trivalent chromium, Mo, Mn, Zr, Ti, Ni, Zn, V, P, Co, La, Ce, rare earth metals, or combinations thereof, for example, SurTec® 650 or SurTec® 650 V or SurTec® 650 RTU (Freudenberg SE, Weinheim, Germany) or CHEMEON® TCP-HF (CHEMEON Surface Technology, Minden, Nevada) or BONDERITE® M-CR T 5900 AERO or BONDERITE® M-NT 65000 AERO (Henkel Corp., Dusseldorf, Germany), or SOCOSURF TCS / SOCOSURF PACS (Socomore, Fort Worth, TX).

Alternatively, conversion coat layer can be created by applying a coat containing trivalent chromium ions and then be exposed to an oxidizer such as, for example, hydrogen peroxide or permanganate. This process converts the trivalent chromium to a hexavalent chromium state, which can provide increased corrosion protection compared to conversion coat containing only trivalent chromium ions, for example, SOCOSURF TCS / SOCOSURF PACS (Socomore, Fort Worth, TX). The conversion coating process, can entail a cleaning and de-oxidation step to remove any native oxides on the surface of the component, prior to application of the conversion coat.

Alternatively, conversion coat layer can be created by creating an oxidation layer formed by, for example, sol-gel, boe-gel, or boehmite-like (steam generated oxide layer) processes. The sol-gel process, for example, can entail a cleaning and de-oxidation step to remove any native oxides on the surface of the component followed by application of the sol-gel to create an oxidation layer. The resultant oxidation layer helps to prevent further oxidation of underlying substrate while also promoting adhesion of subsequently added corrosion resistant layer.

Alternatively, applying a conversion coat can entail additional pretreatment steps or different pretreatment steps when substrate is formed of stainless steel, Ti, Ni, Ti alloy or Ni alloy. For example, a method such as AMS2700 using nitric acid, nitric acid and dichromate, or citric acid can be used to passivate stainless steel. The composition of conversion coat and method of application can be optimized based on the composition of the underlying substrate and the amount of corrosion protection needed in a particular location within a gas turbine engine.

Next, ALD is used to deposit protective coat on top of the conversion coat. ALD first deposits a single monolayer of a first ALD precursor adsorbed on the surfaces of the component, including internal surfaces deep within the core of the component, which may have complex internal geometries. ALD is a self-limiting process and deposits only a single monolayer of the first precursor. Any non-adsorbed first precursor is removed from the system, leaving behind the ALD intermediate coated component, which includes the substrate, a conversion coat layer, and ALD intermediate protective coat.

For Al₂O₃, the first precursor gas can be, for example, a volatile organometallic aluminum such as trimethyl aluminum or aluminum trichloride. For TiO₂, the first precursor gas can be, for example, a volatile titanium precursor such as TiCl₄. For SiO₂, the first precursor gas can be, for example, a volatile organometallic silicon.

Next, a second ALD precursor is added, which bonds only with the adsorbed first precursor in a self-limiting process. Any by-products or unreacted second precursor is removed from the system, leaving behind the component, including a substrate, a conversion coat layer, and a protective layer. For oxides, the second precursor gas can be, for example, plasma O₂, H₂O, and O₃. For nitrides, the second precursor gas can be, for example, ammonia or plasma nitrogen.

ALD is performed for a substance in a specific temperature widow where ALD behavior is obtained. The temperature window is indicated when the growth per cycle is weakly dependent or not dependent on the temperature. Lower temperatures can lead to condensation or low reactivity of the precursor. Higher temperatures can lead to decomposition or desorption of the precursor. In some embodiments the lower limit of the temperature window for the protective coat is no greater than 150°C, no greater than 125°C, or no greater than 110°C, for example. The ALD temperature is the temperature within the window at which the ALD is performed. The ALD temperature can be no greater than 1.3 times, 1.2 times or 1.1 times volatizing temperature of the conversion coat calculated in Kelvin, for example. In some embodiments the ALD temperature is no greater than 150°C, no greater than 130°C, or no greater than 120°C, for example.

The ALD steps can be repeated, forming a second mono-layer making up a protective coat. The ALD steps can be repeated in an iterative manner until a desired thickness of a protective coat is formed.

Next, ALD is used to deposit a corrosion resistant top coat on top of protective coat. The corrosion resistant top coat can be a single mono-layer deposited by ALD as described above with regards to the protective coat. Alternatively, the corrosion resistant top coat can be more than one mono-layer deposited by ALD. The ALD steps can be repeated, forming a second mono-layer making up the corrosion resistant top coat. The ALD steps can be repeated in an iterative manner until a desired thickness of the corrosion resistant top coat is formed.

Optionally, the steps for depositing the preventative coat and the corrosion resistant top coat can be repeated to create a nano-laminate as described above. The layers of the preventative coat and the corrosion resistant top coat can be interspersed with other layers in order to obtain the desired properties.

In some embodiments the ALD process described herein is used to batch coat a system or object. In batch coating an entire system or object, e.g. an airplane air conditioning system, is coated in a single process, rather than coating each piece individually and then assembling them.

Applying a conversion coat, then depositing a protective coat, and then depositing a corrosion resistant top coat using ALD as described herein allows for even non-line-of-site coating of a substrate that would otherwise be difficult or impossible to coat. It also allows for batch coating of complex shapes and systems. The coating provides corrosion resistance in long term acidic and saline environments.

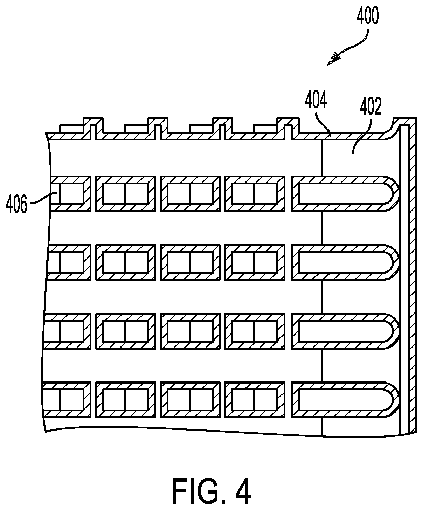

FIG. 4 is a cross-sectional view of a heat exchanger coated with a non-line-of-site topcoat for pretreated aluminum with portions omitted for simplicity. FIG. 4 shows coated heat exchanger 400, component substrate 402, corrosion resistant coating system 404, and fluid flow channels 406.

Coated heat exchanger 400 is a stack of parting sheets that direct fluid flow and allow heat to be transferred from one fluid to another. Coated heat exchanger 400 has a number of fluid flow channels 406 which are torturous passages through coated heat exchanger 400. Coated heat exchanger 400 is made of component substrate 402. Component substrate 402 can be, for example, aluminum or aluminum alloy. Component substrate 402 is encased by corrosion resistant coating system 404 applied as described above. Specifically, the outside of coated heat exchanger 400 is coated and the walls of fluid flow channels 406 are also coated with corrosion resistant coating system 404. Because ALD is used, all surface are covered, even fluid flow channels 406, which would be difficult or impossible to cover with a drip or spray coating because of their dimensions and torturous path. The system described allows for a stable corrosion resistant coating to be applied evenly and thoroughly regardless of the shape or size of the parts involved.

### Example 1: Method for Making

In Example 1, an aluminum alloy substrate is coated using an embodiment of the method described herein. First, the aluminum alloy substrate is coated with a trivalent chromium containing conversion coat. The conversion coat is applied to the aluminum alloy substrate and allowed to react for 3 to 20 minutes. Then, the coat can be oxidized to convert the trivalent chromium to hexavalent chromium by dipping the conversion coated substrate in a 5% by volume solution of hydrogen peroxide for five minutes.

Second, ALD is used to apply a protective coat of titanium dioxide. TiCl₄ is pumped into the reaction chamber at a temperature of 120°C and allowed to react for 0.2-20 seconds. Then the reaction chamber is completely evacuated. Next, water vapor or ozone is pumped into the reaction chamber at a temperature of 120°C and allowed to react for 0.2-20 seconds before the reaction chamber is completely evacuated. The previous two steps are repeated until the desired thickness of the titanium dioxide coat is reached.

Third, a corrosion resistant topcoat of Nb₂O₅ is deposited using ALD. Niobium (V) ethoxide is pumped into the reaction chamber at a temperature of 250°C for 0.2-20 seconds and deposited on the surface of the titanium dioxide. Then the reaction chamber is completely evacuated. Next, water vapor or ozone is pumped into the reaction chamber for 0.2-20 seconds at a temperature of 250°C before the reaction chamber is completely evacuated. The previous two steps are repeated until the desired thickness of the Nb₂O₅ coat is reached.

### Example 2: Salt Spray Testing

In Example 2, various coated and uncoated substrates are subjected to saline environments in order to test the long term anticorrosion capabilities of the coatings, as prescribed in ASTM International Standard B117. First a trivalent or hexavalent chromium conversion coat is applied to an aluminum alloy substrate. Next titanium dioxide is deposited using ALD, as described in Example 1. In some samples, Nb₂O₅ is then deposited using ALD, as described in Example 2. The total thickness of the coating is 250 nm.

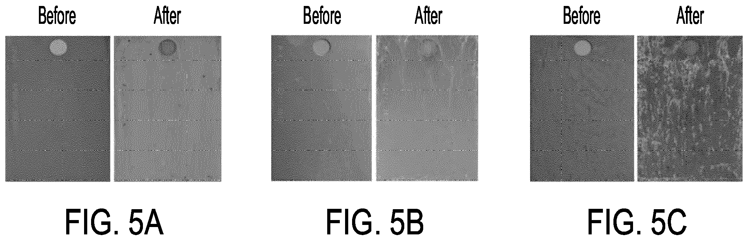

The samples are then subjected to a saline fog with a salt concentration of 5% by weight neutral salt for 168 hours. FIG 5A-5C are a series of photographs showing the before and after results of salt spray testing on coated aluminum alloy substrate samples. FIG 5A is the before and after photos of an aluminum alloy substrate coated with a trivalent chromium conversion coat and titanium dioxide. Minor corrosion is visible. FIG 5B is the before and after photos of an aluminum alloy substrate coated with trivalent chromium conversion coat, titanium dioxide, and Nb₂O₅. Less corrosion is seen on the sample coated with both titanium dioxide and Nb₂O₅ than on the sample coated with titanium dioxide alone. FIG 5C is the before and after photos of an aluminum alloy substrate coated with hexavalent chromium conversion coat and titanium dioxide. Pitting and corrosion is seen in the hexavalent chromium conversion coat with titanium oxide alone.

### Example 3: Dilute Acid Testing

In Example 3, various coated and uncoated substrates are subjected to acidic environments in order to test the long term anticorrosion capabilities of the coatings. First a trivalent or hexavalent chromium conversion coat is applied to an aluminum alloy substrate. Next titanium dioxide is deposited using ALD, as described in Example 1. In some samples, Nb₂O₅ is then deposited using ALD, as described in Example 2. The total thickness of the coating is 250 nm.

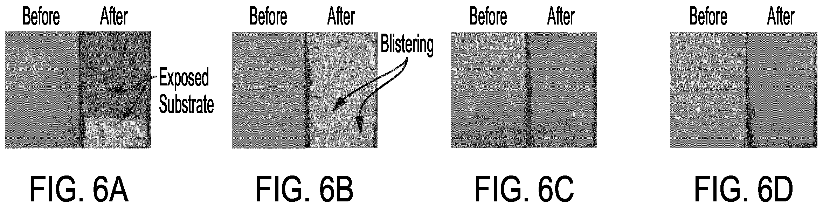

The samples are then submerged in a 5% by volume sulfuric acid solution for 120 hours. FIG 6A-6D are a series of photographs showing the before and after results of acid submersion testing on coated aluminum alloy substrate samples. FIG 6A is the before and after photos of an aluminum alloy substrate coated with a hexavalent chromium conversion coat and titanium dioxide. Corrosion, including exposed substrate is visible after acid submersion. FIG 6B is the before and after photos of an aluminum alloy substrate coated with trivalent chromium conversion coat and titanium dioxide. Some blistering of the titanium dioxide is visible. FIG 6C is the before and after photos of an aluminum alloy substrate coated with hexavalent chromium conversion coat, titanium dioxide, and Nb₂O₅. Corrosion is greatly reduced compared to the hexavalent chromium conversion coat and titanium dioxide alone. FIG 6D is the before and after photos of an aluminum alloy substrate coated with trivalent chromium conversion coat, titanium dioxide, and Nb₂O₅. Corrosion is greatly reduced compared to the trivalent chromium conversion coat and titanium dioxide alone.

### Discussion of Possible Embodiments

The following are non-exclusive descriptions of possible embodiments of the present invention.

A method for coating a substrate, the method comprising: forming a conversion coat layer by subjecting the substrate to a chemical or electro-chemical process; depositing a protective coat onto the conversion coat layer using a first atomic layer deposition; and depositing a corrosion resistant top coat onto the protective coat using a second atomic layer deposition, wherein the conversion coat layer has a volatizing temperature, and wherein the first atomic layer deposition is performed at a deposition temperature that is no greater than 1.3 times the volatizing temperature of the conversion coat layer, calculated in Kelvin.

The system of the preceding paragraph can optionally include, additionally and/or alternatively any one or more of the following features, configuration and/or additional components:
A further embodiment of the system wherein the substrate is formed of aluminum or aluminum alloy.

A further embodiment of the system wherein the substrate is formed of stainless steel, titanium, nickel, copper, tin, bismuth, indium, magnesium, steel, titanium alloy, nickel alloy, copper alloy, tin alloy, bismuth alloy, magnesium alloy, steel alloy or indium alloy.

A further embodiment of the system wherein the conversion coat comprises hexavalent chromium.

A further embodiment of the system wherein the conversion coat comprises non-hexavalent chromium selected from the group consisting of trivalent chromium, Mo, Mn, Zr, Ti, Ni, Zn, V, P, Co, La, Ce, rare earth metals, and combinations thereof.

A further embodiment of the system wherein the conversion coat is an oxidation layer formed by a sol-gel, boe-gel, or boehmite process.

A further embodiment of the system wherein the protective coat comprises titanium dioxide.

A further embodiment of the system wherein the deposition temperature is no greater than 120°C.

A further embodiment of the system wherein the corrosion resistant top coat is formed from the group consisting of a metal oxide, metal nitride, semiconductor, phosphor, fluoride, and combinations thereof.

A further embodiment of the system wherein the protective coat has a thickness of at least 1 nm and no more than 50 nm, the corrosion resistant top coat has a thickness of at least 1 nm and no more than 500 nm, and wherein a total atomic layer deposition deposited coating thickness on the substrate comprising the protective coat and the corrosion resistant top coat is at least 25 nm and no more than 500 nm.

A coated metal article, the article comprising: a substrate comprising a conversion coat layer; an atomic layer deposited protective coat deposited onto the conversion coat layer; and an atomic layer deposited corrosion resistant top coat deposited onto the protective coat; wherein the conversion coat layer has a volatizing temperature and the protective coat has an atomic layer deposition temperature window having an upper limit and a lower limit, and wherein the lower limit is no greater than 1.3 times the volatizing temperature, calculated in Kelvin.

The system of the preceding paragraph can optionally include, additionally and/or alternatively any one or more of the following features, configuration and/or additional components:
A further embodiment of the system, wherein the metal article is selected from a group consisting of a heat exchanger, an air conditioning system, duct work, an air cycle, a heat sink, a radiator, or an electronic box

A further embodiment of the system, wherein the substrate comprises stainless steel, aluminum, titanium, nickel, copper, tin, bismuth, indium, magnesium, steel, aluminum alloy, titanium alloy, nickel alloy, copper alloy, tin alloy, bismuth alloy, magnesium alloy, steel alloy, or indium alloy.

A further embodiment of the system, wherein the conversion coat comprises hexavalent chromium or non-hexavalent chromium selected from the group consisting of trivalent chromium, Mo, Mn, Zr, Ti, Ni, Zn, V, P, Co, La, Ce, rare earth metals, and combinations thereof.

A further embodiment of the system, wherein: the protective coat comprises titanium dioxide.

A further embodiment of the system, wherein the corrosion resistant top coat is formed from the group consisting of a metal oxide, metal nitride, semiconductor, phosphor, fluoride, and combinations thereof.

A further embodiment of the system, wherein the lower limit of the atomic layer deposition temperature is no greater than 120°C.

A further embodiment of the system, wherein: the protective coat has a thickness of at least 1 nm and no more than 50 nm, the corrosion resistant top coat has a thickness of at least 1 nm and no more than 500 nm, and wherein a total atomic layer deposition deposited coating thickness on the substrate comprising the protective coat and the corrosion resistant top coat is at least 25 nm and no more than 500 nm.

A coated heat exchanger comprising a substrate comprising a conversion coat layer; an atomic layer deposited protective coat deposited onto the conversion coat layer; and an atomic layer deposited corrosion resistant top coat deposited onto the protective coat; wherein the conversion coat layer has a volatizing temperature and the protective coat has an atomic layer deposition temperature, and wherein the atomic layer deposition temperature is no greater than 1.3 times the volatizing temperature, calculated in Kelvin.

The system of the preceding paragraph can optionally include, additionally and/or alternatively any one or more of the following features, configuration and/or additional components:
A further embodiment of the system, wherein the substrate comprises aluminum or aluminum alloy

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method for coating a substrate, the method comprising:
forming a conversion coat layer by subjecting the substrate to a chemical or electro-chemical process;
depositing a protective coat onto the conversion coat layer using a first atomic layer deposition; and
depositing a corrosion resistant top coat onto the protective coat using a second atomic layer deposition,
wherein the conversion coat layer has a volatizing temperature, and
wherein the first atomic layer deposition is performed at a deposition temperature that is no greater than 1.3 times the volatizing temperature of the conversion coat layer, calculated in Kelvin.

2. The method of claims 1 or 2, wherein the substrate is formed of aluminum or aluminum alloy.

3. The method of any preceding claim, wherein the substrate is formed of stainless steel, titanium, nickel, copper, tin, bismuth, indium, magnesium, steel, titanium alloy, nickel alloy, copper alloy, tin alloy, bismuth alloy, magnesium alloy, steel alloy or indium alloy.

4. The method of any preceding claim, wherein the conversion coat comprises hexavalent chromium.

5. The method of any preceding claim, wherein the conversion coat comprises non-hexavalent chromium selected from the group consisting of trivalent chromium, Mo, Mn, Zr, Ti, Ni, Zn, V, P, Co, La, Ce, rare earth metals, and combinations thereof.

6. The method of any preceding claim, wherein the conversion coat is an oxidation layer formed by a sol-gel, boe-gel, or boehmite process.

7. The method of any preceding claim, wherein the protective coat comprises titanium dioxide.

8. The method of any preceding claim, wherein the deposition temperature is no greater than 120°C.

9. The method of any preceding claim, wherein the corrosion resistant top coat is formed from the group consisting of a metal oxide, metal nitride, semiconductor, phosphor, fluoride, and combinations thereof.

10. The method of any preceding claim, wherein the protective coat has a thickness of at least 1 nm and no more than 50 nm, the corrosion resistant top coat has a thickness of at least 1 nm and no more than 500 nm, and wherein a total atomic layer deposition deposited coating thickness on the substrate comprising the protective coat and the corrosion resistant top coat is at least 25 nm and no more than 500 nm.

11. A coated metal article, the article comprising:
a substrate comprising a conversion coat layer (104);
an atomic layer deposited protective coat (106) deposited onto the conversion coat layer; and
an atomic layer deposited corrosion resistant top coat (108) deposited onto the protective coat;
wherein the conversion coat layer (104) has a volatizing temperature and the protective coat has an atomic layer deposition temperature window having an upper limit and a lower limit, and
wherein the lower limit is no greater than 1.3 times the volatizing temperature, calculated in Kelvin.

12. The coated metal article of claim 11, wherein the metal article is selected from a group consisting of a heat exchanger, an air conditioning system, duct work, an air cycle, a heat sink, a radiator, or an electronic box.

13. The coated metal article of claims 11 or 12, wherein the substrate comprises stainless steel, aluminum, titanium, nickel, copper, tin, bismuth, indium, magnesium, steel, aluminum alloy, titanium alloy, nickel alloy, copper alloy, tin alloy, bismuth alloy, magnesium alloy, steel alloy, or indium alloy; and/or
wherein the conversion coat comprises hexavalent chromium or non-hexavalent chromium selected from the group consisting of trivalent chromium, Mo, Mn, Zr, Ti, Ni, Zn, V, P, Co, La, Ce, rare earth metals, and combinations thereof; and/or
wherein the protective coat comprises titanium dioxide; and/or
wherein the corrosion resistant top coat is formed from the group consisting of a metal oxide, metal nitride, semiconductor, phosphor, fluoride, and combinations thereof; and/or
wherein the lower limit of the atomic layer deposition temperature is no greater than 120°C; and/or
wherein the protective coat has a thickness of at least 1 nm and no more than 50 nm, the corrosion resistant top coat has a thickness of at least 1 nm and no more than 500 nm, and wherein a total atomic layer deposition deposited coating thickness on the substrate comprising the protective coat and the corrosion resistant top coat is at least 25 nm and no more than 500 nm.

14. A coated heat exchanger comprising:
a substrate comprising a conversion coat layer;
an atomic layer deposited protective coat deposited onto the conversion coat layer; and
an atomic layer deposited corrosion resistant top coat deposited onto the protective coat;
wherein the conversion coat layer has a volatizing temperature and the protective coat has an atomic layer deposition temperature, and
wherein the atomic layer deposition temperature is no greater than 1.3 times the volatizing temperature, calculated in Kelvin.

15. The coated heat exchanger of claim 14, wherein the substrate comprises aluminum or aluminum alloy.
